# EUROPEAN PATENT APPLICATION

(11) **EP 4 395 122 A1**
(43) Date of publication of application: **03.07.2024**
(21) Application number: 23000148.9
(22) Date of filing: 31.10.2023
(51) Int. Cl.: H02J 13/00, G01R 19/25, G01R 21/133, G01R 22/06

(54) **MODULAR INTERNET OF THINGS DIAGNOSTIC SYSTEM BASED ON POWER QUALITY ANALYSIS**

(30) Priority: 31.12.2022 PL 44339022
(71) Applicant: Uniwersytet Morski w Gdyni, 81-225 Gdynia (PL)
(72) Inventor: LISTEWNIK, Karol, 81-603 Gdynia (PL)

(57) **Abstract**

The subject of the invention is a modular Internet of Things diagnostic system based on the analysis of electricity quality and an Internet of Things diagnostics method based on the analysis of electricity quality. The modular diagnostic system and the internet of Things diagnostic method based on the analysis of electricity quality are used in power systems for the ship, shipbuilding and land-based industries, in particular in ship energy, smaller power generating installations and in stiipbuilding, in ship power plants on smaller vessels (e.g. recreational vessels).

## Description

The subject of the invention is a modular internet of Things diagnostic system based on continuous monitoring and analysis of electricity quality and an internet of Things diagnostics method based on the analysis of electricity quality. The modular diagnostic system and the Internet of Things diagnostic method based on the analysis of electricity quality are used in power systems for the shipbuilding and land industries, in particular in the energy Industry: generating sets, energy converters, electrical switchboards, loads in ship power plants and in the diagnostics of electrical machines and devices for the above applications.

According to the definition of the Internet of Things (IoT). first publicly presented by Kevin Ashton, it is a digital network created by Interconnected objects and at the same time a network with the physical world. IoT-based items can directly or indirectly collect, process or exchange data about the physical world via an electrical installation or computer network.

Scientific research indicates the need for data collected by loT sensors during real-time monitoring and control of power systems to be made available to central cloud systems in order to analyze the performance of these systems online and offline [1]. Power disruptions are known to occur and usually result in costly failures of electronic equipment, which translates into critical segments of production processes (including the production, processing and using electricity). Monitoring the quality of electricity is therefore crucial to identifying the causes and taking possible countermeasures to avoid or significantly reduce failures affecting many sectors of the economy, both industrial and commercial [2]. Limiting failures is possible, for example, by generating alarms by the diagnostic system, which allows switching energy sources and/or changing the load characteristics of the power system.

Today, IoT is widely used in smart devices, cloud-based databases and websites used to monitor alerts from electricity distribution systems. Available smart devices have been integrated with a low-cost power quality monitoring chip, giving the economy a cheap and effective system for monitoring transmission networks in almost every low-voltage switchgear. Data recorded by each unit are collected and stored in a cloud database, allowing analysis and reporting of emerging irregularities [1,2]. The solution is also dedicated to residential buildings and low voltage networks.

The patent description PL 223 S44 describes a method for measuring the power of electricity in a medium- and high-voltage distribution network. This method allows reading the network voltage at the point of continuous measurement and measuring the current intensity at the measurement point located along the power lines from the voltage measurement point to a specific power measurement point. This, in turn, allows you to determine the voltage losses between the voltage measurement point and a specific power measurement point, with the voltage and current measured maintaining phase shifts by time synchronization of the measuring devices. The values of the measurements are transmitted via a wireless interface. The known electrical power measurement system in the medium and high voltage distribution network is characterized by the fact that the central unit of the power measurement system is connected via an interface to the local units of the current and phase of the current measurement systems.

Known from the patent description US 2006271314, there is a wireless electricity measurement system composed of a processor connected to a multi-channel transmitter and power consumption meters, which are inductively coupled to the line supplying the receivers. The processor here processes the received information on electricity consumption, sending it wirelessly using the well-known IP network protocol to a monitoring station or via the Internet to a unit archiving or analyzing electricity consumption through appropriate calculations. The invention is applicable to connecting many residential buildings into one network using power lines with the possibility of connecting to the Internet via a power line.

The solutions indicated so far do not solve issues related to the analysis of the energy quality of devices connected to ship's grids and/or electrical machines and devices located in them. Today, such solutions are extremely necessary due to the need to directly measure the phase-to-phase voltage, which is rare in measurement system solutions for monitoring the parameters of ship electrical grids. This is due to the fact that on ships, for reasons of safety against electric shock, the three-wire IT system with insulated earth and directly earthed receivers dominates. Diagnostics of energy sources is also important, including power generators (as an element of a generating set), energy converters and loads, and not only the electrical circuit loads, as current solutions offer. Currently, due to the increasing share of automation systems and electrical energy converters, which increase interference and disturbances in electrical grids, electrical quality analyzers are increasingly used in the shipbuilding industry. The solutions used apply only to individual analyzers monitoring energy quality on the main switchboard busbars. Without performing an advanced analysis as proposed in this solution, the recipient/operator has no knowledge of the source of electrical energy disturbances.

The vast majority of known and proposed inventions are dedicated to land-based industries. The sheer size of diagnostic devices today is quite large and does not allow them to be integrated or placed in the device housing. Hence, the undeveloped area still covers the ship's power system, and in the energy industry: hybrid renewable energy systems (Renewable Energy Sources) and microgeneration systems.

The purpose of implementing this solution is to enable not only periodk/fegular, but above all continuous monitoring of the quality of electrical energy of individual machines and electrical devices operating in the ship's power system. Nowadays, electrical quality analyzers are increasingly used on ships. However, the solutions used concern single analyzers monitoring energy quality on the main switchboard busbars and are too large, which makes them more difficult to install inside elements of the existing systems. Additionally, such solutions do not provide knowledge about the source of interference and disturbances in electrical energy.

The essence of the invention is a modular Internet of Things diagnostic system based on the analysis of electricity quality, composed of a central unit of the electrical parameter measurement system, equipped with a voltage measurement module with voltage dividers and a current measurement module with Hall Effect current sensors and connected via a wireless or wired interface to local units. The monitoring systems, with an AC voltage and current measurement system used as the measurement system, characterized by the fact that it consists of n number of IoT diagnostic modules based on energy quality analysis grouped into 5 modular sections: measurement, analysis, diagnostics, archiving and communications, with all sections connected to the operator panel.

Preferably, each single loT diagnostic module constitutes a miniature element of the diagnostic system, not exceeding dimensions of 100±5 mm in length, 100±5 mm in width, and 50±5 mm in height

Preferably, each single IoT diagnostic module consists of 4 connected components, the first component includes a Front-Ends containing an isolation amplifier for each phase enabling the connection of an effective value of alternating voltage to various input channels with a potential difference of up to ±1500 V, precise voltage dividers of 0.1 % and non-invasive current sensors with the required current value, the second subassembly containing at least 8-channel analog-to-digitai converter with a resolution of 24 bits and a sampling frequency of not less than 25 kHz for each channel, with sampling in the channels taking place simultaneously without shift phase between channels, equipped with 3 channels for 3 phase-to-phase voltages, 3 channels for 3 linear currents, 2 additional channels for current and/or voltage, the third subassembly containing a central computing unit integrated with a network card and the Wi-Fi and Ethernet standard, the fourth subassembly containing the display (W) is placed outside.

Preferably, the central unit from the third subassembly is permanently integrated with the analog-to-digital converter from the second subassembly.

Preferably, the number n of IoT diagnostic modules is selected from the set of natural numbers.

Preferably, modular IoTs are integrated with any source of electricity, any consumer of electricity, any control element, any element converting electricity or any distribution element.

The essence of the invention is also a method of Internet of Things diagnostics based on the analysis of the quality of electricity in the low, medium and high voltage distribution network (medium and high voltages require the additional use of voltage and current transformers), which consists in the readings from the measurement of voltage and current transmitted wirelessly is characterized by the fact that after installing the fourth component, the loT module, and locating the inputs of the first component with input systems at the power measurement point using a modular Internet of Things diagnostic system based on the analysis of electricity quality, periodically or continuously (the choice is up to the system user) are measured and determines the values of instantaneous currents and voltages in three phases of currents and voltages, power, power quality: THD, IHD, frequency, frequency changes, frequency modulation, duration of current and voltage disturbances.

The essence of the proposed solution is also the use of a modular Internet of Things diagnostic system based on the analysis of electricity quality for the diagnosis of damages and disturbances in the quality of energy sources, converters, switchboards and receivers of electricity.

The main advantages of the modular Internet of Things diagnostic system based on power quality analysis are the increased functionality of the use of power quality analyzers by retrofitting more important elements of the power system with a modular Internet of Things diagnostic system based on power quality analysis. The modular system enables monitoring and ongoing diagnostics of all important elements of the power system simultaneously, which allows tracking the path of propagation of disturbances in the power system (network). Identical modules operating in the network ensure relatively easy logistics.

The internet of Things diagnostic system module based on the analysis of electricity quality according to the invention is used wherever the quality of electricity has an impact on operating devices, including in power systems for the shipbuilding and land industries, in particular in ship energy, microgeneration systems and in shipbuilding, in ship power plants and on smaller (e.g. recreational) vessels. The reliability of the ship's power system is increased by earlier sending information about disturbances of the quality of electricity from generators (sources) or electric motors (receivers) significantly separated from the main switchboard. It is very important that marine protection devices available on the market do not ensure proper response, i.e. switching off generating sets/electrical receivers, selectivity of protections, switching on/regulating active harmonic filters, regulating reactive power, even in the event of significant disturbances in the quality of electricity, because they only respond to basic electrical operational parameters, e.g.: impulse, short-term and long-term significant overloads of the power grid.

This solution also enables the measurement of single-phase and three-phase voltages and direct current, making it a universal solution. The proposed solution will allow for the identification of sources of interference, which will enable quick reaction and take actions to reduce their occurrence in the future, including by eliminating the defective element. The IoT diagnostic module is characterized by miniature dimensions not exceeding 100×100×50 mm, playing the role of a measurement, recorder and analyzing three-phase voltage and current waveforms in real time, determining electricity quality parameters, which are compared to the permissible values. The miniature size allows it to be used in any place and device, regardless of the size of the device being diagnosed, without disturbing its integrity.

The subject of the invention is presented in the drawings, in which:
- Fig. 1.: - shows how miniature loT PQ measurement modules cooperate in the system, which are built into individual elements of the power grid in accordance with the first variant of the system according to the Invention;
- Fig. 2: - shows how miniature loT PQ measurement modules cooperate in the system, which are dedicated to individual elements of the power grid without being built in according to the second variant of the system according to the invention.

The modular Internet of Things diagnostic system based on the analysis of electricity quality according to the invention is presented in embodiments that do not limit the invention:

### Example 1

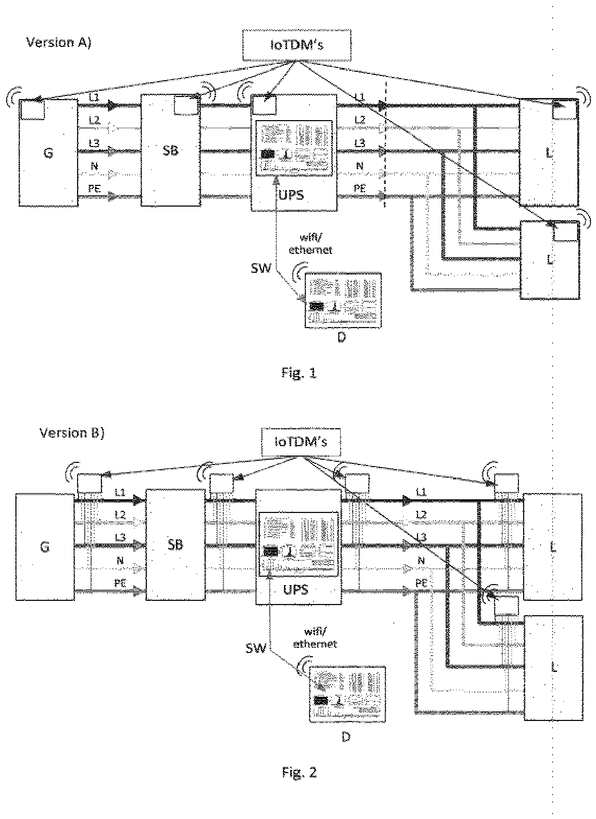

A modular Internet of Things diagnostic system based on the analysis of electricity quality built Into individual elements of the power grid in accordance with the first variant of the system according to the invention is shown in Fig. 1. One module is dedicated to one element of the power grid.

Modular Internet of Things diagnostic system based on monitoring electrical parameters and analysis of power quality, composed of a central unit of the electrical parameter measurement system equipped with a voltage measurement module with voltage dividers (enables measurement of the effective value of alternating voltage U=±1000V, which can be extended) and non-invasive current sensors (they enable measurement of the effective value of alternating current U=±50A, which can be extended) and connected via a wireless Interface to local units of measurement visualization and selected analyses, including power quality and power factors. The system for measuring and analyzing electricity parameters described above constitutes a single IoT module. However, a set of IoT modules can be used as the master diagnostic system, which consists of n number of ioT diagnostic modules based on energy quality analysis. There are 5 appropriate sections implemented in the loT module to manage measurement registration, analysis based on calculated energy quality factors, diagnostics, data archiving and connectivity.

A single IoT diagnostic module consists of 4 connected components, the first component includes a Front-Ends containing an isolation amplifier for each phase enabling the connection of an effective value of alternating voltage to various input channels with a potential difference of up to ±1500 V, precise voltage dividers of 0.1% and non-invasive current sensors with the required current value, the second component containing at least an 8-channel analog-to-digital converter with a resolution of 24 bits and a sampling frequency of not less than 25 kHz for each channel (sampling in the channels takes place simultaneously, which means that there is no phase shift between channels), equipped with 3 channels for 3 phase-to-phase voltages, 3 channels for 3 linear currents, 2 additional channels for current and voltage, e.g. for the excitation current and voltage of a synchronous generator, the third subassembly containing a central computing unit integrated with the network card and Wi-Fi and Ethernet standard, the fourth component is located outside the module and consists of a W display (e.g. laptop, desktop computer, tablet) and dedicated cooperation software used for graphical display of data collected in the module and data management.

All IoTDM diagnostic modules are identical and can be integrated with any electricity source G, any electricity receiver L and any control/distribution element SB. Each IoT diagnostic module with a D display, which can be a tablet, laptop or computer with a dedicated website and/or specialized software for graphical display of data collected in the module and data management, as well as any network access point, allows access to the modular Internet of Things diagnostic system, based on the analysis of electricity quality. In this way, a wireless connection to one of the loT diagnostic modules via a wireless network allows access to any other loT module in a modular system in an It network.

The Internet of Things diagnostic system module based on electricity quality analysis enables monitoring of electricity quality in electricity generators, electricity receivers and electricity distribution elements.

### Example 2

A modular internet of Things diagnostic system based on the analysis of electricity quality, dedicated to Individual elements of the power grid without being built in accordance with the second variant of the system according to the invention, is shown in Fig. 2. One loTDM module is dedicated to one element of the power grid. Each loT diagnostic module (IoTDM) with a display (D), which can be a tablet, laptop or computer with a dedicated website, and any network access point allows access to a modular loT diagnostic system based on the analysis of electricity quality.

All loT diagnostic modules are identical and can be integrated with any electricity source G, any electricity receiver L and any control/distribution element SB.

### Example 3

The method of cooperation of miniature IoT PQ measurement modules in the system, built into individual elements of the power grid in accordance with the first variant of the system according to the invention, is illustrated in Fig. 1, and the method of cooperation of miniature loT PQ measurement modules in the system, which are dedicated to monitoring Individual elements of the power grid without embodiment in accordance with the second variant of the system according to the invention is presented in Fig. 2.

### List of symbols in the drawings:

- 6: - source of electrical energy (e.g. synchronous generator);
- IoTDM: - IoT diagnostic module based on energy quality analysis;
- L: - electricity receiver, load (e.g. electric heating, asynchronous motor);
- SB: - electrical switchboard;
- SW: - software;
- D: - display (e.g. tabiet/computer).

### Refernces:

[1] Viciana E. i in. "An open hardware design for internet of Things power quality and energy saving solutions", Sensors, 2019, 19(3), 627.
[2] Prudenzi A. i in. "Distributed Power Quality monitoring in customer's electrical distribution system", 2019 IEEE International Conference on Environment and Electrical Engineering and 2019 IEEE industrial and Commercial Power Systems Europe (EEEIC / I&CPS Europe), 2019 (DOI: 10.1109/EEEIC.2019.8783784).

## Claims

1. A modular Internet of Things diagnostic system based on the analysis of electricity quality, composed of a central unit of the electrical parameter measurement system, equipped with a voltage measurement module with voltage dividers and connected via a wireless or wired Interface to local units of measurement systems, with the measuring system used consists of an AC voltage and current measurement system **characterized in that**, it consists of n number of loT diagnostic modules based on energy quality analysis, grouped into 5 modular sections: measurement registration, analysis, diagnostics, archiving and communication, with all sections connected to the operator panel.

2. The system according to claim 1, **characterized in that**, each single loT diagnostic module (loTDM) constitutes a miniature element of the diagnostic system not exceeding dimensions of 100±5 mm in length, 100±5 mm in width, and 50±5 mm in height.

3. The system according to claim 1, **characterized in that**, each single IoT diagnostic module (IoTDM) consists of 4 connected subassemblies, the first subassembly including a Front-Ends containing an isolation amplifier for each phase enabling the connection of an effective value of alternating voltage to various input channels with a potential difference of up to ±1500 V, 0.1% voltage dividers, non-invasive current sensors with the required current value, the second component containing at least an 8-channel analog-to-digital converter with a resolution of 24 bits and a sampling frequency of not less than 25 kHz for each channel, with sampling in channels is carried out simultaneously without phase shift between channels, equipped with 3 channels for 3 phase-to-phase voltages, 3 channels for 3 linear currents, 2 additional channels for current and voltage, the third component containing a central computing unit integrated with the network card and the Wi-Fi standard, and Ethernet, the fourth component containing the display (W) located outside the module.

4. The system according to claim 1 and claim 3, **characterized in that**, the central unit from the third subassembly is permanently integrated with the analog-to-digital converter from the second subassembly.

5. The system according to claim 1, **characterized in that**, the number n of IoT diagnostic modules (DJE) is selected from the set of natural numbers.

6. The system according to claim 1, **characterized in that,** the modular sections (IoTDM) are integrated with any electrical energy source (G), any electrical energy receiver (L), any control element or any distribution element (SB).

7. A method of Internet of Things diagnostics based on the analysis of the quality of electricity in the low, medium and high voltage distribution network, consisting in the readings from the measurement of voltage and current transmitted wirelessly, **characterized in that**, they are taken after installing the fourth component, the loT module, and positioning inputs of the first component with input systems at the power measurement point using a modular Internet of Things diagnostic system based on the analysis of electricity quality, the values of instantaneous currents and voltages in three phases of currents and voltages, power, THD, IHD coefficients are periodically/regularly or continuously measured and determined, frequency, frequency changes, frequency modulation, duration of current disturbances.

8. Application of a modular Internet of Things diagnostic system based on the analysis of electricity quality to diagnose faults and disturbances in energy quality of sources, converters, switchboards and receivers of electricity (L).
